(19) **Europäisches Patentamt / European Patent Office / Office européen des brevets**

(11) **EP 1 796 270 A1**

(12) # EUROPEAN PATENT APPLICATION

(43) Date of publication:
**13.06.2007 Bulletin 2007/24**

(51) Int Cl.:
**H03L 7/107** (2006.01)    **H03L 7/18** (2006.01)

(21) Application number: **06250199.4**

(22) Date of filing: **16.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **08.12.2005 US 297622**

(71) Applicant: **VIA Technologies, Inc.**
**Hsin-Tien,**
**Taipei 231,**
**Taiwan R.O.C. (TW)**

(72) Inventors:
• **Azam, Mir S.**
**Austin, TX 78732 (US)**
• **Lundberg, James R.**
**Austin, TX 78703 (US)**

(74) Representative: **O'Connell, David Christopher**
**HASELTINE LAKE,**
**Redcliff Quay**
**120 Redcliff Street**
**Bristol BS1 6HU (GB)**

(54) **Damping coefficient variation arrangement in a phase locked loop**

(57)    A damping coefficient variation mechanism for a PLL including a bias controller, a gain control circuit, and an oscillator circuit. The PLL receives an input clock signal and provides an output clock at a frequency that is the frequency of the input clock multiplied by a clock multiplier. The bias controller has an input receiving a loop control signal and an output providing one or more bias signals. The gain control circuit has bias inputs receiving the bias signals, a gain control input receiving a gain control value, and an output providing a control signal. The oscillator circuit has an input receiving the control signal and an output providing the output clock signal. The gain control circuit provides the control signal to adjust frequency of the output clock signal based on the loop control signal at a gain determined by the gain control value.

FIG. 2

EP 1 796 270 A1

**Description**

CROSS-REFERENCE TO RELATED APPLICATIONS

This application is related to the following co-pending U.S. Patent Applications, which are filed on the same day as this application, which have a common assignee and at least one common inventor, and which are herein incorporated by reference in their entirety for all intents and purposes:

| SERIAL NUMBER | FILING DATE | TITLE |
| --- | --- | --- |
| (CNTR.2243) | 12/08/2005 | SYSTEM AND METHOD FOR OPTIMIZING PHASE LOCKED LOOP DAMPING COEFFICIENT |
| (CNTR.2245) | 12/08/2005 | PHASE LOCKED LOOP DAMPING COEFFICIENT CORRECTION MECHANISM |

BACKGROUND OF THE INVENTION

FIELD OF THE INVENTION

The present invention relates to phase locked loop (PLL) circuits, and more particularly to a damping coefficient variation mechanism in a PLL circuit that enables dynamic optimization of the PLL damping coefficient based upon the value of a clock multiplier.

DESCRIPTION OF THE RELATED ART

Phase locked loop (PLL) circuits are typically used by electronic devices and the like to synchronize one or more clock signals for controlling the various operations of the device. Because operations within an integrated circuit can be performed much faster than operations between integrated circuits, PLL circuits are often used within an integrated circuit to generate an internal clock signal at some multiple of the external clock frequency. In many applications, the internal clock signal is derived from an external clock reference that is provided to the integrated circuit as well as to other components within a system so that inter-system operations are synchronized. For instance, an exemplary bus clock in a computer system operating at 300 megahertz (MHz) may be used to derive an internal microprocessor core clock signal operating at 3 gigahertz (GHz), which represents a tenfold increase in frequency. A clock multiplier N determines the ratio between the bus clock (or external clock) and core clock (or internal clock) frequencies. Some systems are static in which the clock multiplier N is fixed. Other systems are dynamic in which the clock multiplier is adjustable for various purposes, such as changing the mode of operation of the integrated circuit or electronic circuit (e.g., switching between various power modes, such as standby, low-power, hibernation, etc.).

One skilled in the art appreciates that the response characteristics of a conventional PLL are inversely proportional to the square of the clock multiplier N and proportional to the square of the oscillator gain KV. The damping coefficient $\vartheta$ for a PLL circuit is as shown in the following proportion (1):

$$\vartheta \propto \sqrt{\frac{1}{N} \times IC \times KV \times R^2 \times C} \qquad (1)$$

where N is the clock multiplier, IC is a charge pump current magnitude, KV is the oscillator gain, and R and C are the resistance and capacitance, respectively, of the RC loop filter components of the PLL. A typical loop filter for a PLL includes a series RC filter having a time constant in accordance with the desired properties of the PLL, which include maximizing locking speed and minimizing jitter. In some embodiments, a small capacitor is provided in parallel with the series RC components, in which case Proportion 1 is modified accordingly. The loop filter generates a loop control signal which is provided to a variable oscillator circuit to control the phase and/or frequency of the internal clock signal. In one specific configuration, the loop filter generates a loop voltage which is employed to modulate the amount of current that is supplied to oscillator cells within a current controlled oscillator (ICO). A greater amount of current results in a faster internal clock and a lesser amount of current results in a slower internal clock.

One skilled in the art also appreciates that to maximize spectral purity, the damping coefficient $\vartheta$ of the PLL should be relatively constant. It has been shown that the ideal damping coefficient value is approximately 0.707. As advances in integrated circuit fabrication techniques have enabled devices to be scaled to less than 100-nanometer channel lengths, it is not uncommon to find requirements for a PLL circuit that support clock multipliers ranging from 1 to 30 or more times a given reference frequency. And it is very common that the clock multiplier is dynamically modified during operation to adjust the operating mode. The damping coefficient of the conventional PLL, however, varies from under damped to over damped in response to changes of the clock multiplier to achieve the desired given operating range. In this manner, the conventional PLL does not provide the desired spectral purity.

One skilled in the art further appreciates that the spectral purity of the clock signals within an integrated circuit, particularly a pipelined device such as a microprocessor, directly impacts operating speed because the internal logic must be designed to operate under worst-case conditions. Accordingly, it is very desirable to improve the spectral purity of present day PLL circuits. For some applications that have a fixed reference clock frequency and a fixed clock multiplier N, a PLL can be configured which achieves an acceptable spectral quality. Conventional PLL circuits are not suitable, however, for applications that dynamically vary the reference frequency and/or the clock multiplier or ratio N since such conventional PLL circuits generate undesirable jitter when N varies which significantly reduces spectral quality. In particular, when jitter due to variation of the damping coefficient $\vartheta$ exists in a PLL, operational circuits must be designed to operate under worst-case conditions. At 2 GHz, for example, one percent jitter in a PLL reduces the amount of work that can be performed during a given clock cycle.

The spectral quality problems must be resolved to maximize efficiency and work performed as operating speed increases. It is desired to improve the spectral quality of PLL circuits employed in modem day circuits including integrated circuits and the like.

SUMMARY OF THE INVENTION

A damping coefficient variation mechanism for a phase locked loop (PLL) circuit according to an embodiment of the present invention includes a bias controller, a gain control circuit, and an oscillator circuit. The PLL circuit receives an input clock signal and a clock multiplier and provides an output clock at a frequency that is the clock multiplier times the frequency of the input clock. The bias controller has an input receiving a loop control signal and an output providing at least one bias signal. The gain control circuit has at least one bias input receiving one or more bias signals, a gain control input receiving a gain control value, and an output providing a control signal. The oscillator circuit has an input receiving the control signal and an output providing the output clock signal. The gain control circuit provides the control signal to adjust frequency of the output clock signal based on the loop control signal at a gain determined by the gain control value.

In one embodiment, the oscillator circuit includes at least one current controlled oscillator cell having an input receiving a current control signal. In another embodiment, the gain control value includes one or more enable signals and the gain control circuit includes multiple current sources. Each current source is selectively enabled by a corresponding enable signal and adjusts its current level provided to the input of the current controlled oscillator based on the bias signal(s). In one embodiment, each current source provides an equivalent current level when enabled. Alternatively, each successive current source provides twice the current level of a previous current source when enabled forming a binary weighted array.

The bias controller may include a first and second outputs respectively providing first and second bias signals. The current sources may be implemented as an array of P-channel devices forming multiple legs of devices, where the devices of each leg are coupled in series between a voltage supply and the input of the oscillator circuit. In this case, each current source may include a first gate receiving the first bias signal, a second gate receiving the second bias signal, and a third gate receiving a corresponding enable signal. In one configuration, the P-channel devices of each current source have substantially equal widths. Alternatively, the P-channel devices are sized in a binary weighted fashion across successive ones of the current sources. The gain control circuit may further include a nominal current source which provides a nominal current level to the input of the current controlled oscillator in which the nominal current level is adjusted by the bias signal(s).

An adjustable oscillator for dynamically controlling a damping coefficient of a PLL circuit according to an embodiment of the present invention includes an oscillator circuit, a gain control circuit, and a damping controller. The PLL circuit provides a loop control signal indicative of an error between first and second clock signals for generating a third clock signal having a frequency which is a clock multiplier times the frequency of the second clock signal. The oscillator circuit has a control input and an output providing the third clock signal. The gain control circuit has a first input receiving the loop control signal, a second input receiving a gain control value, and an output providing a control signal to the control input of the oscillator circuit. The gain control circuit varies the control signal based on the loop control signal at a gain determined by the gain control value. The damping controller has an input for receiving the clock multiplier and an output providing the gain control value, where the damping controller adjusts gain in response to changes of the clock multiplier.

The oscillator circuit may be a current controlled oscillator (ICO) circuit having a current control input and an output providing the third clock signal. The gain control circuit may include a bias controller and a current generator. The bias controller has an input receiving the loop control signal and an output providing at least one bias signal. The current generator has at least one bias input receiving the bias signal(s), a gain control input receiving the gain control value, and an output providing the current control signal. The current generator may be implemented an array of P-channel devices as previously described.

A PLL circuit having a dynamically controllable damping coefficient according to an embodiment of the present invention includes a detector, a charge pump, a filter circuit, a gain-controlled oscillator circuit, a frequency divider, and a damping controller. The detector compares a first clock signal with a second clock signal and provides an error signal indicative thereof. The charge pump has an input receiving the error signal and an output providing a pulse signal indicative thereof. The filter circuit is coupled to the charge pump for converting the pulse signal to a loop control signal. The gain-controlled oscillator circuit has a first input receiving the loop control signal, a second input receiving a gain control value, and an output providing a third clock signal. The gain-controlled oscillator adjusts frequency of the third clock signal based on the loop control signal at a gain determined by the gain control value. The frequency divider has a first input receiving the third clock signal, a second input receiving a clock multiplier, and an output providing the second clock signal having with a frequency that is based on a frequency of the third clock signal divided by the clock multiplier. The damping controller has an input receiving the clock multiplier and an output providing the gain control value, where the damping controller adjusts the gain of the oscillator circuit in response to changes of the clock multiplier.

The gain-controlled oscillator circuit may include a bias controller, a gain control circuit, and an ICO circuit. The bias controller has an input receiving the loop control signal and an output providing at least one bias signal. The gain control circuit has at least one bias input receiving the bias signal(s), a gain control input receiving the gain control value, and an output providing a current control signal. The ICO circuit has an input receiving the current control signal and an output providing the third clock signal. The gain control circuit adjusts the current control signal to adjust the frequency of the third clock signal based on the loop control signal at a gain determined by the gain control value.

The gain control value may be implemented as multiple gain adjust signals. The gain control circuit may include multiple P-channel current legs coupled in parallel in which each P-channel current leg is selectively enabled by a corresponding gain adjust signal.

A method of varying a damping coefficient of a PLL, which generates an output clock as a clock multiple of an input clock, includes generating a control signal to control frequency of an oscillator based on a loop control signal of the PLL, converting the clock multiple into a gain control value, and controlling the gain of the oscillator based on the gain control value. The method may include selectively activating each of multiple current sources providing current to a current controlled oscillator. The method may include converting the loop control signal to at least one bias signal used to bias the current sources. The method may include generating at least one bias voltage provided to a gate of a first P-channel device of each current source and selectively activating a second P-channel device of each current source.

BRIEF DESCRIPTION OF THE DRAWINGS

The benefits, features, and advantages of the present invention will become better understood with regard to the following description, and accompanying drawings where:

FIG. 1 is a simplified block diagram of a conventional PLL circuit implemented according to prior art;

FIG. 2 is a simplified block diagram of an exemplary PLL circuit implemented according to an embodiment of the present invention;

FIG. 3 is a more detailed schematic and block diagram of the loop filter, the oscillator circuit and the damping controller implemented according to a more specific embodiment of the PLL circuit of FIG. 2;

FIG. 4 is a graph diagram plotting simulation results of the frequency of the CORECLK signal versus the VLP signal for several discrete values of gain;

FIG. 5 is a flowchart diagram illustrating a method for optimizing the damping coefficient of a PLL circuit;

FIG. 6 is a more detailed schematic and block diagram of a damping coefficient variation mechanism implemented according to an exemplary embodiment of the present invention which may be used to implement the gain controlled oscillator circuit of FIGs 2 or 3;

FIG. 7 is a flowchart diagram illustrating a method of implementing and programming the damping coefficient variation mechanism of FIG. 6 according to an exemplary embodiment of the present invention; and

FIG. 8 is a flowchart diagram providing additional details of converting the loop control signal into a third clock signal for a general case and when using the damping coefficient variation mechanism of FIG. 6.

DETAILED DESCRIPTION

The following description is presented to enable one of ordinary skill in the art to make and use the present invention as provided within the context of a particular application and its requirements. Various modifications to the preferred embodiment will, however, be apparent to one skilled in the art, and the general principles defined herein may be applied to other embodiments. Therefore, the present invention is not intended to be limited to the particular embodiments shown and described herein, but is to be accorded the widest scope consistent with the principles and novel features herein disclosed.

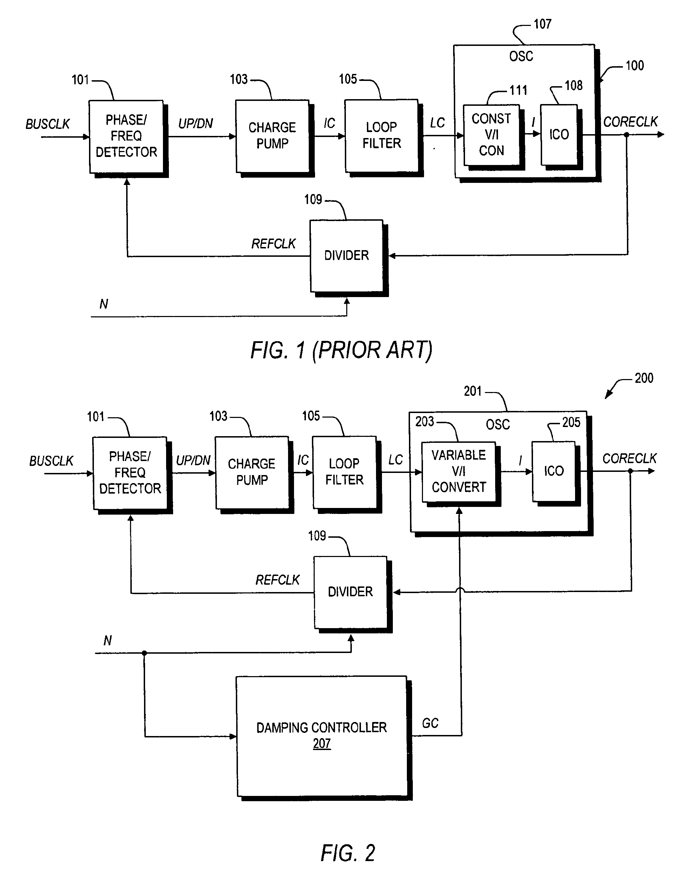

The inventors of the present application have recognized the need to solve the problems associated with the present art, particularly with respect to the limitations imposed on pipelined devices when conventional PLL circuits are employed. They have therefore developed a damping coefficient variation mechanism for use by a PLL circuit within an integrated circuit or an electronic device which enables dynamic optimization of the PLL damping coefficient based upon the value of a clock multiplier, as will be further described below with respect to FIGURES 1 - 8. When employed in a pipeline architecture, undesirable jitter may be minimized so that pipelined devices can be designed to increase the amount of work performed between pipelined stages due to the increased spectral purity provided to a core clock signal.

FIG. 1 is a simplified block diagram of a conventional PLL circuit 100. A first clock signal BUSCLK is provided to a first input of a phase/frequency detector 101, which receives a second clock signal REFCLK at a second input. The phase/frequency detector 101 compares the frequency and/or phase between the REFCLK and BUSCLK signals and provides an up/down error signal UP/DN that indicates any differences in phase and/or frequency. A charge pump 103 has an input receiving the error signal UP/DN and generates a current pulse signal IC at its output, which is provided to a loop filter 105. Although the magnitude of the IC current pulse is typically static, the sign (positive pulse or negative pulse) of the IC signal generally indicates the direction to align REFCLK with BUSCLK and the duration of the IC current pulse typically indicates the amount of correction needed to align the BUSCLK and REFCLK clock signals with each other. The loop filter 105 converts the IC signal to a loop control signal LC, which is provided to a control input of a constant V/I converter 111 within an oscillator circuit 107. The constant V/I converter 111 converts the loop control signal LC to a current signal I, which is provided to the input of a current controlled oscillator 108. The constant V/I converter 111 converts the loop control signal LC according to a constant proportional relationship. The oscillator circuit 107 generates a core clock signal CORECLK, which is provided to one input of a divider circuit 109. The divider circuit 109 receives a frequency or clock multiplier N at a second input, and converts the CORECLK signal to the REFCLK signal which is provided to the phase/frequency detector 101. The clock multiplier N determines the frequency relationship between BUSCLK and CORECLK. The divider circuit 109 divides the frequency of CORECLK by the multiplier N to derive the frequency of REFCLK, which is provided back to the phase/frequency detector 101 to close the loop. In this manner, the PLL circuit 100 operates to multiply the frequency of BUSCLK by the multiplier N to achieve the frequency of CORECLK, and to synchronize CORECLK with BUSCLK.

The PLL circuit 100 may be implemented on an integrated circuit or the like, where the BUSCLK signal and multiplier N are received externally or off-chip and the CORECLK signal is used on-chip. The present invention, however, contemplates configurations other than integrated circuits and generally applies to PLL circuits used by any electronic device. The loop filter 105 filters the IC signal and generates the loop control signal LC, which is used to control the frequency of the CORECLK signal in standard feedback operation. The LC signal may be in the form of a current signal or a voltage signal, and the oscillator circuit 107 may be current or voltage controlled as known to those skilled in the art. The spectral quality of the PLL circuit 100 is acceptable as long as the BUSCLK signal and the clock multiplier N are static and do not change. As described previously, however, for applications in which it is desired to dynamically vary the frequency of BUSCLK or the value of the clock multiplier N, the spectral quality of the PLL circuit 100 is not acceptable since it generates undesirable jitter in response to such changes due to an increased of decreased current signal I in constant proportion to changes in the loop control signal LC. With reference to Proportion 1, the gain KV of the oscillator circuit 107 is generally fixed, so that changes in N result in undesirable changes in the damping coefficient $\vartheta$ causing jitter and reducing the spectral quality of the PLL circuit 100.

FIG. 2 is a simplified block diagram of an exemplary PLL circuit 200 implemented according to an embodiment of the present invention. The PLL circuits 100 and 200 include several similar components which are given identical reference numbers. In particular, the phase/frequency detector 101, the charge pump 103, the loop filter 105 and the divider circuit 109 are included in the PLL circuit 200 and operate in substantially the same manner. The divider 109 divides CORECLK by N to provide REFCLK to the phase/frequency detector 101, which generates the UP/DN error signal provided to the charge pump 103, which generates the IC signal to the loop filter 105, which generates the loop control signal LC. The oscillator circuit 107 of the PLL circuit 100 is replaced with a gain controlled oscillator circuit 201, which receives the loop control signal LC and which generates the CORECLK signal. The oscillator circuit 201 includes an variable V/I converter circuit 203 having a first input receiving the LC signal and an output providing a control signal I. The I signal is provided to a variable oscillator circuit 205, which provides the CORECLK signal at its output. A damping controller circuit 207 is added which receives the clock multiplier N and which provides a gain control signal GC to another input of the variable V/I converter circuit 203. In one embodiment, the variable oscillator circuit 205 is a current controlled oscillator (ICO) 205. An alternative embodiment is also contemplated where the variable oscillator circuit 205 is a voltage controlled oscillator (not shown).

The oscillator circuit 201 operates in a similar manner as the oscillator circuit 107, except that the gain of the oscillator circuit 201 is controlled or otherwise adjusted based on the GC signal. Gain KV is defined as the change in frequency (F) of the CORECLK signal, or $\Delta F$, as a function of the change in the LC signal, or $\Delta LC$, or $KV = \Delta F/\Delta LC$, where the forward slash "/" denotes division. For example, if the frequency is measured in GHz and the LC signal is a voltage signal measured in Volts (V), then the gain KV has units of Hz/V. For a given value of the clock multiplier N, say N1, the damping controller 207 asserts a corresponding value of the GC signal, say GC1, which causes the variable V/I converter circuit 203 to operate at a corresponding gain KV, or KV1. Thus, the variable V/I converter circuit 203 converts the LC signal to the I signal which is used to control the frequency of the CORECLK signal provided by the variable oscillator circuit 205 at the corresponding gain of KV1. For GC1, the gain KV1 determines the relationship between LC and CORECLK employed in the control loop.

When the multiple N is changed to a new value, say N2, the damping controller 207 changes the GC signal to a corresponding new value, say GC2, which causes the oscillator circuit 201 to operate at a corresponding new gain, say KV2. In order to optimize the spectral quality of the PLL circuit 200, the damping controller 207, the variable V/I converter circuit 203 and the ICO 205 are configured to minimize changes of the damping coefficient $\vartheta$. As defined in Proportion 1, the damping coefficient $\vartheta$ is a function of the square-root of KV/N, so that for any change of N, the gain KV of the oscillator circuit 201 is modified by the same factor (e.g., N). In this manner, the change in N is effectively canceled by or compensated with the change in KV so that any change of the damping coefficient is minimized. For example, if N is doubled from 10 to 20, then the gain KV is also doubled so that the damping coefficient remains unchanged according to Proportion 1. Since changes of the damping coefficient are minimized in response to changes of the clock multiplier N by concomitantly changing the oscillator gain, the spectral quality of the PLL circuit 200 is improved relative to the spectral quality of the PLL circuit 100.

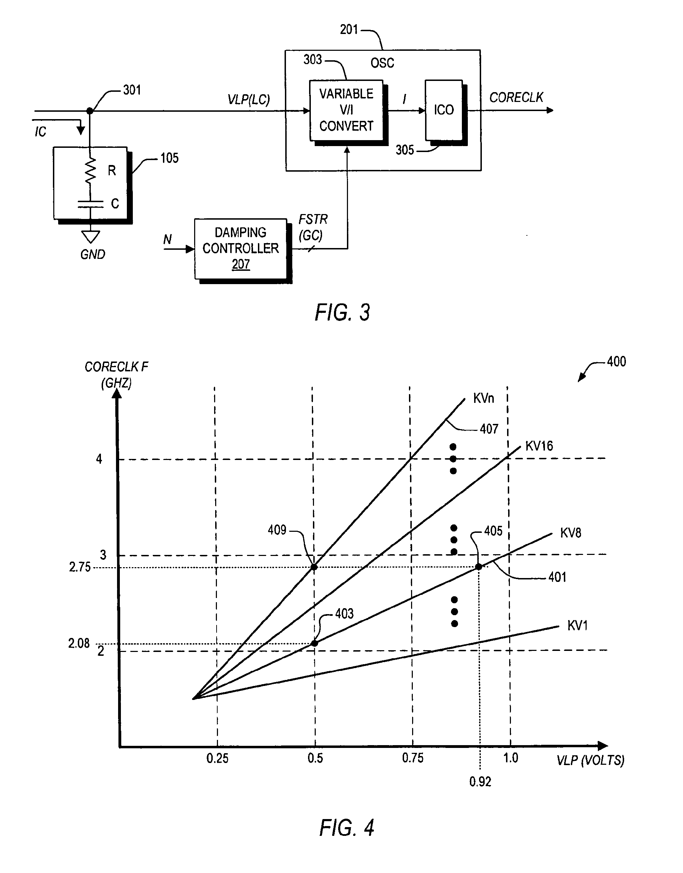

FIG. 3 is a more detailed schematic and block diagram of the loop filter 105, the oscillator circuit 201 and the damping controller 207 implemented according to a more specific embodiment of the PLL circuit 200. The IC signal is a current pulse applied via a node 301 to a resistor R and capacitor C coupled in series between node 301 and ground (GND). Node 301 develops a loop control voltage VLP, which is provided to the oscillator circuit 201. In this case, the VLP signal serves as the loop control signal LC (shown in parenthesis). The VLP signal is applied to a variable voltage to current (V/I) converter 303 within the oscillator circuit 201, which converts the VLP signal to a current signal I, which is provided to the input of a current controlled oscillator (ICO) 305. In the illustrated embodiment, the damping controller 207 receives the clock multiplier N and generates or decodes corresponding signals on a frequency strobe bus FSTR provided to a gain control input of the V/I converter 303. In this case, the FSTR bus serves as the gain control signal GC (shown in parenthesis). In one embodiment, the FSTR bus includes multiple digital signals to control or adjust gain between multiple discrete gain values, each corresponding to discrete values of the clock multiplier N. The signals of the FSTR bus direct the V/I converter 303 to increase/decrease current I to oscillator cells within the ICO 305 in order to stabilize the PLL damping coefficient $\vartheta$ as a function of N. Thus, the damping controller 207 directs the V/I converter 303 via the FSTR bus to increase or decrease the current I to control gain to maintain the damping coefficient of the PLL circuit 200 stable with respect to changes in the value of the clock multiplier N. With reference to Proportion 1 for the damping coefficient $\vartheta$, N is the clock multiplier provided to the damping controller 207, IC is the current provided via node 301 to the loop filter 105, R and C are the resistance and capacitance values of the loop filter 105, and KV is the gain of the oscillator circuit 201 defined as the change in frequency of the CORECLK signal per change of voltage of the VLP signal, or $KV = \Delta F/\Delta VLP$. As previously noted, if a capacitor is placed in parallel with the series RC filter, Proportion 1 is modified accordingly; yet the principles of the present invention remain unchanged since changes of the damping coefficient are minimized in the same manner.

FIG. 4 is a graph diagram plotting simulation results of the frequency (F) of the CORECLK signal in GHz versus the VLP signal in Volts (V) for several discrete values of gain KV ranging from 1 to n, or KV1 to KVn, assuming that the PLL circuit 200 is designed to operate from 400 MHz to 4 GHz over a nominal loop filter voltage range of 0.25 V to 0.75 V. The discrete values of gain KV are determined by corresponding discrete values of the current I provided to the ICO 305. A conventional PLL, such as the PLL circuit 100, would be characterized by only one of the gain curves KVn:KV1 because gain of the oscillator circuit 107 is not modulated as a function of the clock multiplier N. Consequently, the slope of one particular KV curve would be the gain KV that would be used in Proportion 1 to determine the damping coefficient $\vartheta$ of the PLL circuit 100 for all values of N. As the clock multiplier N varies for the conventional PLL circuit 100, so varies the damping coefficient $\vartheta$ in accordance with Proportion 1 because KV, R, and C are fixed. But in contrast to the conventional PLL circuit 100, the PLL circuit 200 according to the present invention keeps the value of the damping coefficient $\vartheta$ relatively constant by directing the ICO 305 via bus FSTR to increase or decrease current I to the oscillator cells when the clock multiplier N changes. Changing the current I results in a change to the gain KV of the oscillator, which compensates for the change in the clock multiplier N, thus keeping the value of the damping coefficient $\vartheta$ relatively constant.

As an example and with reference to FIG. 4, assume that the oscillator circuit 107 of the conventional PLL circuit 100 has a gain curve 401 (i.e., KV8) and that the PLL circuit 100 is operating at a point 403 in which the frequency of CORECLK is about 2.08 GHz for a VLP voltage of about 0.5V. In this case, assume that the loop control signal LC for the PLL circuit 100 is the VLP voltage. If N changes to a new value to adjust the frequency of CORECLK to a new frequency of 2.75 GHz, then the PLL circuit 100 must adjust to a new operating point 405 along curve 401 associated with a VLP voltage of about 0.92V. With reference to the PLL circuit 100, the increase of N causes the divider 109 to reduce the frequency of REFCLK, and the phase/frequency detector 101 responds by asserting the UP/DN error signal to increase the frequency of REFCLK to once again equal the frequency of BUSCLK. The charge pump 103 and the loop filter 105 respond by increasing VLP towards 0.92V until the frequency of CORECLK eventually settles in to the new target frequency of 2.75 GHz. The entire control loop of the PLL circuit 100 must respond to reach and settle on the new frequency. And note that during this process, the damping coefficient $\vartheta$ is reduced since it is a function of the square-root of 1/N. The result is a significant amount of jitter, a change of the damping coefficient and reduced spectral purity. This in turn increases the time of response and reduces the amount of work that can be performed in the circuit employing the conventional PLL circuit 100.

In comparison, assume that the oscillator circuit 201 of the PLL circuit 200 includes all of the gain curves (i.e., KVn:KV1) and that the PLL circuit 200 is initially operating at the same point 403 of the gain curve 401 in which the frequency of CORECLK is about 2.08 GHz for a VLP voltage of about 0.5V. Also assume that the loop control signal LC for the PLL circuit 200 is the VLP voltage. It is desired to select a gain curve that maintains a mid-range level of VLP so that VLP remains relatively constant for changes of the clock multiplier N. In this case, when N changes to a new value to adjust the frequency of CORECLK to a new frequency of 2.75 GHz, the damping controller 207 adjusts the gain control signal GC (e.g., new value of FSTR), which adjusts the gain of the oscillator circuit 201 to a new gain curve 407 (i.e., shown as gain = KVn) to maintain the same mid-level value of VLP of approximately 0.5 V. Thus, the PLL circuit 200 adjusts to a new operating point 409 along the gain curve 407. With reference to the PLL circuit 200, the increase of N may initially cause the divider 109 to begin reducing the frequency of REFCLK. However, the change of the GC value causes the variable V/I converter circuit 203 to adjust the I signal to keep the damping coefficient at substantially the same value after the ICO 205 aligns the phase of the CORECLK to the new frequency of 2.75 GHz as it was prior to the change. In the embodiment of FIG. 3, the damping controller 207 adjusts the value of FSTR to switch the variable V/I converter 303 to assert a new value of source current I. Thus, The damping coefficient $\vartheta$ remains constant since the change of N is compensated by the change in gain KV. The result is a significantly reduced amount of jitter and a stable damping coefficient thereby resulting in relatively high spectral purity. This enables reduced time of response and a concomitant increase in the amount of work that can be performed in the integrated circuit or electronic device.

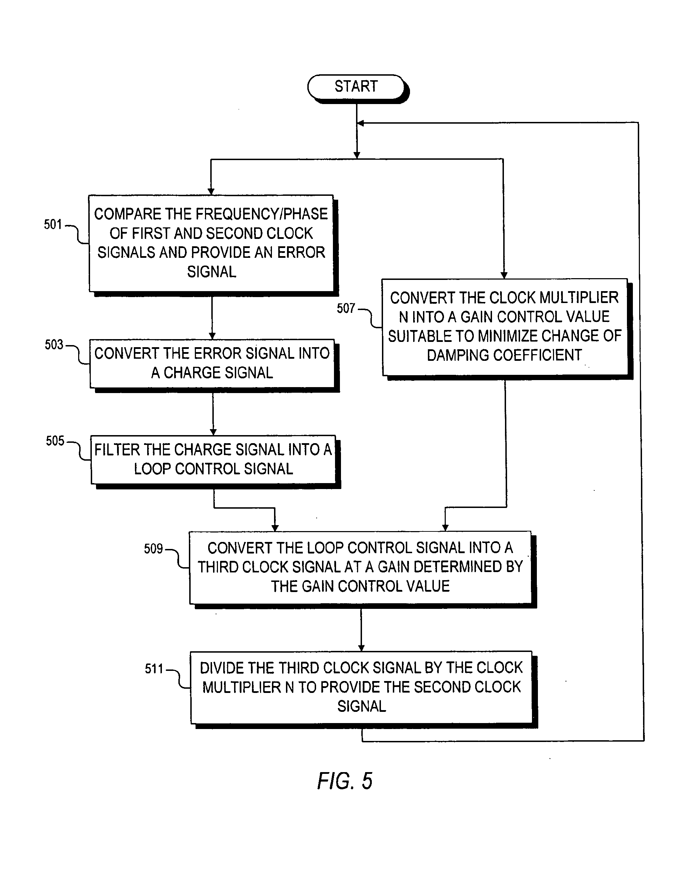

FIG. 5 is a flowchart diagram illustrating a method for optimizing the damping coefficient of a PLL circuit according to an exemplary embodiment of the present invention. Several blocks, including blocks 501, 503, 505 and 511 are similar to that of a conventional PLL. At a block 501, the frequency and phase of first and second clock signals are compared and a corresponding error signal is provided. In various embodiments as described above, the first signal is a bus clock or external clock or the like, the second clock is a feedback or reference clock fed back from a frequency divider in the control loop of the PLL, and the error signal is an up/down signal. At next block 503, the error signal is converted to a charge signal. PLL circuits typically employ a charge pump or the like to convert the error signal to a charge signal. At next block 505, the charge signal is filtered into a loop control signal. The loop control signal may have any suitable form, such as a current signal or a voltage signal as known to those skilled in the art. In one embodiment, for example, the charge signal is a current signal provided to a resistor-capacitor filter, which develops a loop control voltage or the like as known to those skilled in the art. Meanwhile at block 507, the clock multiplier N is converted to a gain control value suitable to minimize the change of the damping coefficient of the PLL in response to changes of the clock multiplier value. At next block 509, the loop control signal is converted into a third clock signal at a gain determined by the gain control value. The conversion between the loop control signal and the third clock signal may be performed by a variable oscillator circuit or the like, such as a current controlled oscillator or a voltage controlled oscillator. At last block 511, the frequency of the third clock signal is divided by the clock multiplier N to provide the second clock signal, and operation returns to blocks 501 and 507.

The function of block 507 may be performed concurrently with any one or more of the blocks 501 - 505 as shown, although this is not necessarily the case. In an integrated circuit embodiment, for example, a detector compares the frequency/phase of an input bus clock with a reference clock while coefficient logic converts an external clock multiplier to the gain control value. The conversion between the clock multiplier and gain control value depends on the characteristics and configuration of the variable oscillator circuit and the range and configuration of the loop control signal. The loop control signal represents a conversion between the error signal from the detector and the frequency of the third clock signal which is controlled to minimize the error. The gain of the oscillator controls the relative change of frequency of the third clock signal in response to changes of the loop control signal. In one embodiment, a nominal or mid-level value of the loop control signal is selected and the damping controller adjusts the gain control value to maintain about the same level of the loop control signal for each value of the clock multiplier. The gain control values may be determined experimentally and stored within the damping controller. The damping controller may be implemented in any suitable manner, such as a lookup table or the like.

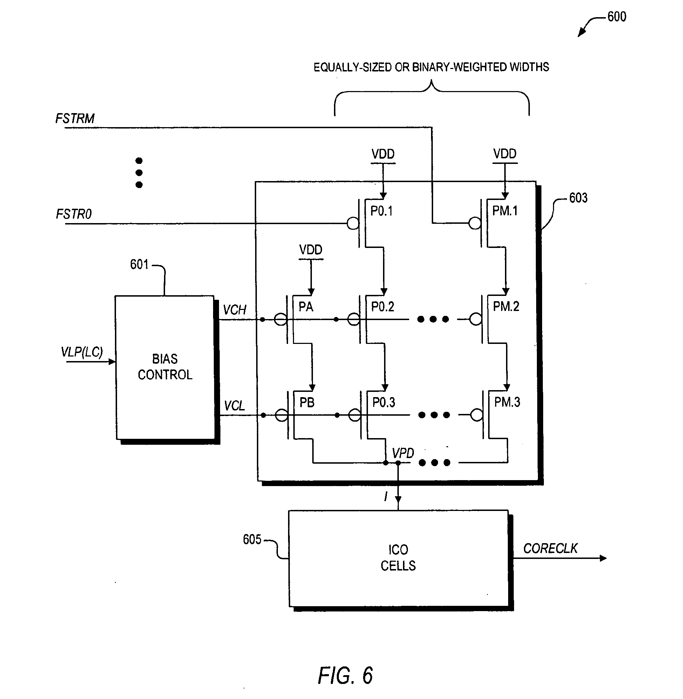

FIG. 6 is a more detailed schematic and block diagram of a damping coefficient variation mechanism 600 implemented according to an exemplary embodiment of the present invention which may be used to implement the gain controlled oscillator circuit 201. The mechanism 600 includes a bias controller 601 which receives the loop control signal as the loop filter voltage signal VLP and which generates two voltage bias signals VCL and VCH. It is appreciated that the loop control signal LC may be provided in any suitable format and that the voltage VLP is an exemplary embodiment. In the embodiment illustrated, the VCL and VCH bias signals are provided to bias an array 603 of P-channel devices, which collectively form a gain control circuit for the ICO cells 605. In particular, the VCL signal is distributed to the gates of M+2 P-channel devices PB, P0.3:PM.3 and the VCH signal is distributed to the gates of M+2 P-channel devices PA, P0.2:PM.2 within the array 603, in which M is an integer greater than zero.

The drain of each of the PA, P0.2:PM.2 devices is coupled to a source of a corresponding one of the PB, P0.3: PM.3 devices, so that corresponding ones of the PA, P0.2:PM.2 and PB, P0.3:PM.3 devices are effectively coupled in series. The drains of the PB, P0.3:PMN.3 devices are coupled together at a node VPD, which is coupled to an input of one or more current controlled oscillator (ISO) cells 605, collectively implementing the ICO 305, and having an output providing the CORECLK signal. The source of PA is coupled to a voltage supply, such as VDD. Another set of M+1 P-channel devices P0.1:PM.1 is provided within the array 603, in which the drain of P0.1 is coupled to the source of P0.2, and so on up to PM.1 having its drain coupled to the source of PM.2. The source of each of the P-channel devices P0.1: PM.1 is coupled to VDD. The FSTR bus includes M+1 signals FSTR0:FSTRM, in which the FSTR0 signal is provided to the gate of P0.1 and so on up to the FSTRM signal which is provided to the gate of PM.1. The current signal I is provided to the ICO cells 605 from the P-channel devices via the node VPD.

The array 603 is organized into P-channel "legs" PA:PB and Px.1:Px.3 in which "x" is an index that ranges from 0 to M. Each leg effectively forms a current source that supplies a portion if the total current I to the ICO cells 605 via the node VPD. The first leg PA:PB is a nominal current source that is always enabled. The first or upper P-channel devices P0.1 to PM.1 of the remaining M+1 current source legs serves as an enable device for enabling the respective current source depending upon the state of the corresponding one of the FSTR enable signals. The FSTR bus is illustrated as an (M+1)-bit bus comprising signals FSTR[M:0]. The FSTR[M:0] signals collectively form a digital value in which each signal is an enable bit for each of the current sources. The FSTR0 bit selectively enables the first P-channel device P0.1 of the second current source comprising the P-channel devices P0.1:P0.3, the FSTR1 bit selectively enables the first P-channel device of the third current source and so on up to the last bit FSTRM which selectively enables the first P-channel device PM.1 of the last current source comprising the P-channel devices PM.1:PM.3. In the illustrated embodiment, each FSTR bit is asserted high or logic one (1) to disable a corresponding current source and is asserted low or logic zero (0) to enable the current source. The voltage bias signals VCL and VCH adjust the activation level of the P-channel devices PA:PB and the lower P-channel devices Px.2:Px.3 of each current source leg. In the illustrated embodiment, the higher the VLP voltage, the more the P-channel devices Px.2:Px.3 of each current source leg are turned on to source more current of each activated current source leg. Since the number of activated current source legs determines the oscillator gain, the array 603 functions as a gain control circuit for the oscillator.

The voltage bias signals VCL and VCH directly determine the amount of current that is supplied to the ICO cells 605 via node VPD from the P-channel device array 603 as a function of the value of the loop filter voltage signal VLP for a given value of the FSTR bus. A typical conventional PLL 100 only includes devices similar to the P-channel devices PA and PB which are controlled by VLP to provide current at a predetermined gain. In the mechanism 600, however, the effects of the bias signals VCL and VCH are modulated by the P0.1:PM.1 devices coupled in series with P0.2:PM.2 devices as driven by the FSTR bus. According to the state of the FSTR[M:0] signals, as determined by the damping controller 207, selected ones of the P0.1:PM.1 devices are switched on thereby activating corresponding P-channel legs, which source a selected amount of additional current through to the ICO cells 605 to increase the gain KV of the oscillator 201. As noted above, the state of each of the FSTR[M:0] signals is selected according to the clock multiplier N to provide an oscillator gain KV which maintains the damping coefficient $\vartheta$ of the oscillator 201 approximately constant (or otherwise minimizes changes of the damping coefficient with changes of the clock multiplier N).

In one embodiment, the P-channel devices PA, PB, P0.1:PM.1, P0.2:PM.2, P0.3:PM.3 are all of equal widths so that turning on a particular current source leg Px.1:Px.3 of the array 603 results in an additional amount of current supplied to the ICO cells 605 equal to that supplied through the P-channel devices PA:PB. Hence, turning on one leg doubles the current, turning on 4 legs quadruples the current, etc. One embodiment of the present invention contemplates a value of M equal to 3. Alternatively, each successive leg of the array 603 includes P-channel devices that are twice the width of the P-channel devices in a previous leg, thus providing for a binary weighted approach to current modulation. Thus, the P2.1:P2.3 devices are twice the width (i.e., twice the current sourced) of the P1.1:P1.3 devices, which are twice the width of the P0.1:P0.3 devices, and so on. Accordingly, FSTR[M:0] provides for $2^{M+1}$ levels of current granularity to the ICO cells 605. In one embodiment, M equals five, thus providing for 32 levels of granularity to control the damping of the oscillator 201. In a further alternative, rather than doubling the width of successive legs of the array, the parallel legs of P-channel devices are employed to effectively double the current capacity.

The PA and PB devices are sized to provide a nominal current through the node VPD that enables the ICO cells 605 to operate within a selected frequency range. In a conventional PLL design, the PA and PB devices had to be sized for sufficient gain to achieve the entire range of frequencies for all expected values of the clock multiplier N. And in such conventional designs, since the gain is fixed for each N value, the damping coefficient $\vartheta$ of the oscillator significantly varied for each N value across the frequency range resulting in a PLL with relatively poor spectral purity. With reference to FIG. 4, for example, in the conventional design only one of the gain curves is available so that one curve (e.g., KVn or higher) had to be selected to achieve the entire frequency range for all expected values of the clock multiplier N. In contrast, in at least one embodiment of the present invention, the PA and PB devices need only be sized to provide a minimum gain at the lowest N value (or the lower N values) for one or more lower clock multiplier values, where the gain is selected to target a suitable nominal value of the VLP signal (e.g., 0.5V as illustrated in the above embodiments). With reference to FIG. 4, for example, the present invention enables multiple gain curves so that the PA and PB devices are configured to achieve the appropriate gain curve (e.g., KV1) for only the lowest value of the clock multiplier N.

In the illustrated embodiment the ICO cells 605 receive current from the array 603 of P-channel devices as controlled by the FSTR[M:0] and VLP signals. In an alternative embodiment, the array may instead be configured as N-channel devices in which the ICO cells 605 are coupled to VDD and the N-channel device array (not shown) is coupled between the ICO cells 605 and ground. The bias controller 601 is modified accordingly to provide the appropriate voltage levels on the VCH and VCL bias signals. In yet another embodiment, voltage controlled oscillator (VCO) cells (not shown) are contemplated in which the array is configured to provide various voltage levels for controlling oscillator gain and frequency.

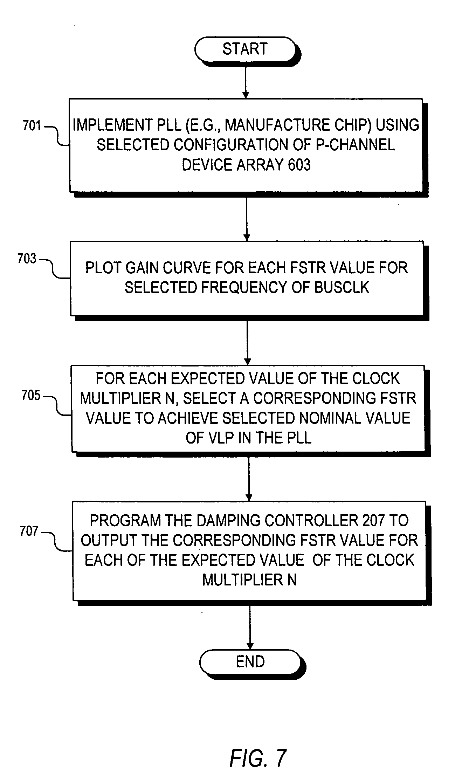

FIG. 7 is a flowchart diagram illustrating a method of implementing and programming the damping coefficient variation mechanism 600 according to an exemplary embodiment of the present invention. At block 701, the PLL is implemented or built using a selected array configuration, such as, for example, manufacturing an integrated circuit that integrates the PLL with the damping coefficient variation mechanism 600. The selected configuration of the array 603 of P-channel devices includes the type and relative sizes (including widths) of the P-channel devices of the array 603. For example, it is determined whether the widths of P-channel devices for each leg are equal or distributed in binary weighted manner between successive current source legs as previously discussed. At next block 703, the gain curve for each FSTR value is plotted or otherwise determined for a selected frequency of BUSCLK of the implemented integrated circuit or electronic system. At next block 705, an FSTR value is selected to correspond with each expected value of the clock multiplier N. The FSTR value is typically selected to achieve a nominal value of VLP in the PLL (e.g., 0.5 V). At final block 707, the damping controller 207 of the implemented device is programmed to provide a corresponding FSTR value for each expected value of the clock multiplier N. In one embodiment, for example, the damping controller 207 includes a lookup table or the like in which the clock multiplier N serves as an address or index value used to address and access the corresponding FSTR value, which is asserted on the FSTR bus.

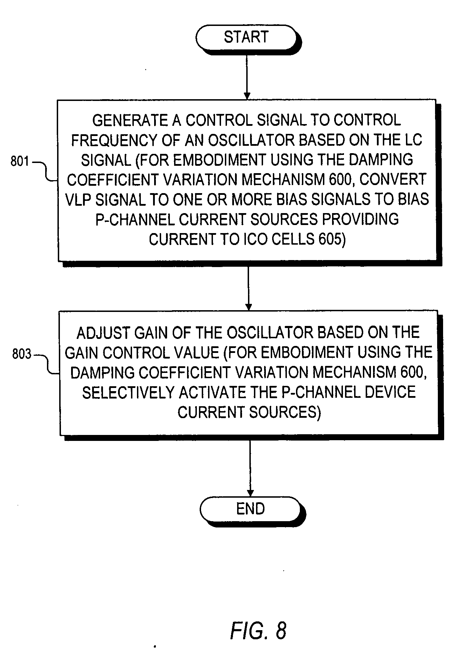

FIG. 8 is a flowchart diagram providing additional details of block 509 for a general case and when using the damping coefficient variation mechanism 600. The clock multiplier N is converted at block 507 to the gain control value. At first block 801, a control signal is generated to control the frequency of an oscillator based on the LC signal. For the specific embodiment employing the damping coefficient variation mechanism 600, this includes converting the VLP signal to one or more bias signals (e.g., VCL, VCH) used to bias current sources providing current the ICO cells 605. In the embodiment illustrated, the current sources are implemented with series-coupled P-channel devices as shown in FIG. 6. At next block 803, the gain of the oscillator is adjusted based on the gain control value. For the specific embodiment employing the damping coefficient variation mechanism 600, this includes selectively activating the current sources with separate signals of the gain control value, such as the FSTR[M:0] signals shown in FIG. 6.

Less complex embodiments of the present invention presume fixed values of charge pump current IC and the R and C components of the loop filter 105. Although these embodiments are less complex, it is noted that the present invention also comprehends embodiments that dynamically modulate one or more of these values IC, R, C as well as KV in order to maintain the stability of the damping coefficient $\vartheta$. One embodiment of the present invention contemplates simulating n oscillator gain curves KVn:KV1 as a function of n values of the FSTR bus over a desired operating frequency range and as a function of a desired loop filter voltage range. In this case, the damping controller 207 is configured to generate a discrete value of FSTR for each value of N such that the associated gain KV of the oscillator circuit 201 results in a relatively constant value for the damping coefficient $\vartheta$. One embodiment selects the values of FSTR such that $\vartheta$ is held approximately equal to 0.707, however the present invention contemplates alternative embodiments where the damping coefficient is held at values other than 0.707. A nominal loop filter voltage embodiment selects the aforementioned values of FSTR at a mid-range value of the loop filter voltage VLP (e.g., 0.5 V).

Several benefits and advantages are achieved with a damping coefficient variation mechanism in a phase locked loop according to embodiments of the present invention. One advantage is that undesirable jitter may be controlled and minimized in the PLL circuit since variations of the damping coefficient may be minimized with corresponding changes of the clock multiplier between the core (output or internal) clock and the bus (input or external) clock. Another advantage is that since damping coefficient variations are minimized, pipelined devices can be designed to increase the amount of work performed between pipelined stages due to the increased spectral purity provided to the internal core clock signal.

Although the present invention has been described in considerable detail with reference to certain preferred versions thereof, other versions and variations are possible and contemplated. For example, the array 603 of P-channel device may be implemented as an array of N-channel devices coupled between the ICO cells 605 and ground. Those skilled in the art should appreciate that they can readily use the disclosed conception and specific embodiments as a basis for designing or modifying other structures for providing out the same purposes of the present invention without departing from the spirit and scope of the invention as defined by the appended claims.

**Claims**

1. A damping coefficient variation mechanism for a phase locked loop (PLL) circuit which receives an input clock signal and a clock multiplier and which provides an output clock at a frequency that is the clock multiplier times the frequency of the input clock, said damping coefficient variation mechanism comprising:

   a bias controller having an input receiving a loop control signal and an output providing at least one bias signal;
   a gain control circuit, coupled to said bias controller, having at least one bias input receiving said at least one bias signal, a gain control input receiving a gain control value, and an output providing a control signal; and
   an oscillator circuit having an input receiving said control signal and an output providing the output clock signal;

   wherein said gain control circuit provides said control signal to adjust frequency of the output clock signal based on said loop control signal at a gain determined by said gain control value.

2. The damping coefficient variation mechanism of claim 1, wherein said oscillator circuit comprises at least one current controlled oscillator cell having an input receiving a current control signal.

3. The damping coefficient variation mechanism of claim 2, wherein:

   said gain control value comprises a plurality of enable signals; and

   wherein said gain control circuit comprises a plurality of current sources, each adjusting current level provided to said input of said current controlled oscillator based on said at least one bias signal, and wherein each current source is selectively enabled by a corresponding one of said plurality of enable signals.

4. The damping coefficient variation mechanism of claim 3, wherein each of said plurality of current sources provides an equivalent current level when enabled.

5. The damping coefficient variation mechanism of claim 3, wherein each successive one of said plurality of current sources provides twice the current level of a prior current source when enabled.

6. The damping coefficient variation mechanism of claim 3, wherein:

   said bias controller has a first output providing a first bias signal and a second output providing a second bias signal; and

   wherein each of said plurality of current sources comprises a plurality of P-channel devices coupled in series between a voltage supply and said input of said oscillator circuit, and wherein said plurality of P-channel devices of each current source comprises a first gate receiving said first bias signal, a second gate receiving said second bias signal, and a third gate receiving a corresponding one of said plurality of enable signals.

7. The damping coefficient variation mechanism of claim 6, wherein said plurality of P-channel devices of said plurality of current sources have substantially equal widths.

8. The damping coefficient variation mechanism of claim 6, wherein said plurality of P-channel devices are sized in a binary weighted fashion across successive ones of said plurality of current sources.

9. The damping coefficient variation mechanism of claim 3, wherein said gain control circuit further comprises a nominal current source providing a nominal current level to said input of said current controlled oscillator in which said nominal current level is adjusted by said at least one bias signal.

**10.** A method of varying a damping coefficient of a phase lock loop (PLL) which generates an output clock as a clock multiple of an input clock, comprising:

generating a control signal to control frequency of an oscillator based on a loop control signal of the PLL;
converting the clock multiple into a gain control value; and
controlling the gain of the oscillator based on the gain control value.

**11.** The method of claim 10, wherein said controlling the gain of the oscillator comprises selectively activating each of a plurality of current sources providing current to a current controlled oscillator.

**12.** The method of claim 11, wherein said generating a control signal comprises converting the loop control signal to at least one bias signal used to bias the current sources.

**13.** The method of claim 12, each current source comprising a stack of P-channel devices coupled in series, wherein said generating a control signal comprises generating at least one bias voltage provided to a gate of a first P-channel device of each current source and wherein said selectively activating each of the plurality of current sources comprises selectively activating a second P-channel device of each current source.

FIG. 1 (PRIOR ART)

FIG. 2

FIG. 3

FIG. 4

START

501 — COMPARE THE FREQUENCY/PHASE OF FIRST AND SECOND CLOCK SIGNALS AND PROVIDE AN ERROR SIGNAL

507 — CONVERT THE CLOCK MULTIPLIER N INTO A GAIN CONTROL VALUE SUITABLE TO MINIMIZE CHANGE OF DAMPING COEFFICIENT

503 — CONVERT THE ERROR SIGNAL INTO A CHARGE SIGNAL

505 — FILTER THE CHARGE SIGNAL INTO A LOOP CONTROL SIGNAL

509 — CONVERT THE LOOP CONTROL SIGNAL INTO A THIRD CLOCK SIGNAL AT A GAIN DETERMINED BY THE GAIN CONTROL VALUE

511 — DIVIDE THE THIRD CLOCK SIGNAL BY THE CLOCK MULTIPLIER N TO PROVIDE THE SECOND CLOCK SIGNAL

*FIG. 5*

*FIG. 6*

START

701 — IMPLEMENT PLL (E.G., MANUFACTURE CHIP) USING SELECTED CONFIGURATION OF P-CHANNEL DEVICE ARRAY 603

703 — PLOT GAIN CURVE FOR EACH FSTR VALUE FOR SELECTED FREQUENCY OF BUSCLK

705 — FOR EACH EXPECTED VALUE OF THE CLOCK MULTIPLIER N, SELECT A CORRESPONDING FSTR VALUE TO ACHIEVE SELECTED NOMINAL VALUE OF VLP IN THE PLL

707 — PROGRAM THE DAMPING CONTROLLER 207 TO OUTPUT THE CORRESPONDING FSTR VALUE FOR EACH OF THE EXPECTED VALUE OF THE CLOCK MULTIPLIER N

END

*FIG. 7*

START

801 ─┐ GENERATE A CONTROL SIGNAL TO CONTROL
FREQUENCY OF AN OSCILLATOR BASED ON THE LC
SIGNAL (FOR EMBODIMENT USING THE DAMPING
COEFFICIENT VARIATION MECHANISM 600, CONVERT
VLP SIGNAL TO ONE OR MORE BIAS SIGNALS TO BIAS
P-CHANNEL CURRENT SOURCES PROVIDING
CURRENT TO ICO CELLS 605)

803 ─┐ ADJUST GAIN OF THE OSCILLATOR BASED ON THE
GAIN CONTROL VALUE (FOR EMBODIMENT USING THE
DAMPING COEFFICIENT VARIATION MECHANISM 600,
SELECTIVELY ACTIVATE THE P-CHANNEL DEVICE
CURRENT SOURCES)

END

*FIG. 8*

**European Patent Office**

**EUROPEAN SEARCH REPORT**

Application Number

EP 06 25 0199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 568 888 A (KIMURA ET AL) 4 February 1986 (1986-02-04) | 1,10 | H03L7/107 H03L7/18 |
| Y | * column 7, line 43 - column 8, line 5; figure 1 * | 2-9, 11-13 | |
| X | US 6 683 502 B1 (GROEN ERIC D ET AL) 27 January 2004 (2004-01-27) | 1 | |
| Y | * column 4, line 63 - column 6, line 39 * | 2-13 | |
| X | GB 2 183 947 A (THE * PLESSEY COMPANY PLC; * THE PLESSEY COMPANY PLC) 10 June 1987 (1987-06-10) | 1 | |
| Y | * the whole document * | 2-13 | |
| X | US 2002/089381 A1 (MULLGRAV ALLAN L ET AL) 11 July 2002 (2002-07-11) | 1 | |
| Y | * paragraph [0029] - paragraph [0031] * | 2-13 | |

TECHNICAL FIELDS SEARCHED (IPC)

H03L

The present search report has been drawn up for all claims

| Place of search | Date of completion of the search | Examiner |
|---|---|---|
| Munich | 4 April 2006 | Kahn, K-D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 06 25 0199

This annex lists the patent family members relating to the patent documents cited in the above-mentioned European search report.
The members are as contained in the European Patent Office EDP file on
The European Patent Office is in no way liable for these particulars which are merely given for the purpose of information.

04-04-2006

| Patent document cited in search report | | Publication date | Patent family member(s) | | Publication date |
|---|---|---|---|---|---|
| US 4568888 | A | 04-02-1986 | NONE | | |
| US 6683502 | B1 | 27-01-2004 | NONE | | |
| GB 2183947 | A | 10-06-1987 | EP  0248871  A1 | | 16-12-1987 |
|  |  |  | WO  8703760  A1 | | 18-06-1987 |
| US 2002089381 | A1 | 11-07-2002 | NONE | | |